# EUROPEAN PATENT APPLICATION

(11) **EP 2 377 903 A1**
(43) Date of publication of application: **19.10.2011**
(21) Application number: 09834689.3
(22) Date of filing: 03.12.2009
(51) Int. Cl.: C09J 7/00, C09J 11/04, C09J 133/14, C09J 163/00, C09J 171/10, H01B 1/00, H01B 1/20, H01B 5/16, H01L 21/52, H01L 21/60

(54) **FILM ADHESIVE AND ANISOTROPIC CONDUCTIVE ADHESIVE**

(30) Priority: 25.12.2008 JP 2008329286
(71) Applicant: Sumitomo Electric Industries, Ltd., Chuo-ku Osaka-shi Osaka 541-0041 (JP)
(72) Inventor: TOSHIOKA, Hideaki, Osaka-shi Osaka 554-0024 (JP); OKUDA, Yasuhiro, Osaka-shi Osaka 554-0024 (JP)
(74) Representative: Cross, Rupert Edward Blount
(86) International application number: PCT/JP2009/070289
(87) International publication number: WO 2010/073885

(57) **Abstract**

Provided is a film adhesive that has a high flexibility and a high adhesion strength and is easy to prepare by mixing. The film adhesive contains, as essential components, a bisphenol A phenoxy resin having a molecular weight of 30,000 or more, an epoxy resin having a molecular weight of 500 or less, a glycidyl methacrylate copolymer, a rubber-modified epoxy resin, and a latent hardener. Preferably, the weight of the glycidyl methacrylate copolymer per epoxy equivalent is 1000 or less.

## Description

### Technical Field

The present invention relates to a film adhesive for bonding and electrically connecting electronic components and substrates including electrodes, circuits, etc.

### Background Art

As the size of electronic appliances is decreased and function advanced, connection terminals for component parts have also become increasingly smaller and narrower. Thus, in the field of electronics packaging, various film adhesives that can easily connect between such terminals are used. For example, film adhesives are used to bond integrated circuit (IC) chips onto flexible printed wiring board (flexible printed circuit or FPC) and IC chips onto glass boards having indium tin oxide (ITO) electrode circuits, etc.

Among the film adhesives, there are anisotropic conductive adhesives (ACF: anisotropic conductive film) that contain electric conductive particles in a resin composition and non-conductive films (NCF) that do not contain electric conductive particles. Film adhesives of both types are used by being placed between objects to be connected and heated and pressurized to bond the objects. When an anisotropic conductive adhesive is used, the resin in the adhesive is fluidized by application of heat and pressure and seals the gap between opposing electrodes on objects to be connected while part of the electric conductive particles is trapped between the opposing electrodes, thereby establishing an electrical connection. When a non-conductive film is used, the resin component is fluidized by application of heat and pressure and the electrodes, i.e., the objects to be connected, come into direct contact with each other, thereby establishing an electrical connection. These film adhesives are required to exhibit electric conduction performance of lowering the resistance (connection resistance) between electrodes that oppose each other in the thickness direction and insulation performance of increasing the resistance (insulation resistance) between electrodes that are adjacent to each other in a surface direction.

Film adhesives are required to have high connection reliability since they are used in connecting the peripheral parts of precision mechanical equipment such as liquid crystal displays (LCD). Thus, in addition to the conduction/insulation performance, environment-resistant characteristics are required. For example, the performance is evaluated through a high temperature and high humidity test, a heat cycle test, etc.

An epoxy-type thermosetting resin composition is mainly used as an insulating resin composition which constitutes the film adhesive. For example, a resin composition combining a curing agent and a thermosetting resin, such as an epoxy resin, a phenoxy resin, or the like is widely used.

An epoxy resin has high heat resistance and moisture resistance but the hardened material thereof is extremely brittle and lacks toughness (flexibility). Accordingly, detachment may occur due to generation of cracks and the adhesion strength is low. An epoxy resin exhibits adhesion strength as it undergoes curing shrinkage under heat during connection; however, curing shrinkage generates stress in the adhesive interface and the interior of the adhesive. The stress caused by the curing shrinkage increases in proportion to the storage elastic modulus of the adhesive. Since an epoxy resin exhibits high storage elastic modulus after cure, the stress generated during the curing shrinkage is high, the residual stress remains in the adhesive interface and the interior of the adhesive, and interfacial detachment occurs once the adhesive is released in a high-temperature high-humidity state.

In order to compensate for the shortcomings of the epoxy resin, a rubber material such as acrylic rubber or nitrile butadiene rubber (NBR) or a thermoplastic resin such as an acryl resin is used in combination with an epoxy resin to impart flexibility to the film adhesive. For example, Patent Literature 1 discloses an anisotropically conductive member for circuit connection, in which an epoxidized butadiene is used as a component that imparts flexibility in combination with a naphthalene-based epoxy resin and a phenoxy resin.

### Summary of Invention

### Technical Problem

The aforementioned materials that impart flexibility have very low compatibility with the epoxy resin. A film adhesive containing such materials is in a so-called seaisland structure state in which the epoxy resin is dispersed in the rubber material and the like instead of being completely dissolved in the rubber material. In order to create this dispersed state, the components constituting the film adhesive must be thoroughly mixed, i.e., mixing must be conducted with a special agitator or the production conditions must be stringently controlled.

According to Patent Literature 1, the compatibility with the epoxy resin is enhanced by using, as a component that imparts the flexibility, epoxidized polybutadiene to which functional groups (epoxy groups) are introduced. However, since the ratio of the functional groups is low compared to the molecular weight, this is less effective.

The present invention addresses the problems mentioned above and provides a film adhesive that has high flexibility, can enhance the adhesion strength, and is composed of components that can be easily mixed.

### Solution to Problem

The present invention provides a film adhesive that includes, as essential components, a bisphenol A phenoxy resin having a molecular weight of 30,000 or more, an epoxy resin having a molecular weight of 500 or less, a glycidyl methacrylate copolymer, a rubber-modified epoxy resin, and a latent hardener (first invention of the subject application).

A glycidyl methacrylate copolymer is a polymer prepared by copolymerizing glycidyl methacrylate with another copolymerizable monomer and has an epoxy group branching from the polymer main chain. Since the compatibility with the epoxy resin is enhanced and the phase separation is suppressed, the copolymer is easily mixed with the epoxy resin. Since it is a flexible component, flexibility can be imparted to the film adhesive and the adhesion strength can be enhanced.

The weight of the glycidyl methacrylate copolymer per epoxy equivalent is preferably 1000 or less (second invention of the subject application). When the weight per epoxy equivalent is large, i.e., when the number of epoxy groups in the molecular chain is small, the compatibility with the epoxy resin is lowered. The epoxy groups in the molecular chain can form a network structure by reacting with the epoxy resin during curing. As a result, thermal expansion can be suppressed under high-temperature, high-humidity conditions, and the long-term connection reliability can be improved. When the weight per epoxy equivalent is larger than 1000, the number of the reactive sites that react with the epoxy resin is small and an effective network structure cannot be formed. Thus, the heat resistance and moisture resistance are degraded.

The glass transition temperature (Tg) of the glycidyl methacrylate copolymer is preferably lower than the glass transition temperature of the bisphenol A phenoxy resin (third invention of the subject application). In general, in order to improve the heat resistance and moisture resistance, the glass transition temperatures of the resin components contained in the film adhesive after curing must be high. This is because a high glass transition temperature decreases the coefficient of thermal expansion in a high temperature range and reduces changes in characteristics in a high-temperature, high-humidity environment.

The film adhesive preferably further includes electric conductive particles (fourth invention of the subject application). A film adhesive containing electric conductive particles can be used as an anisotropic conductive adhesive.

Electric conductive particles having an aspect ratio of 5 or more are preferably oriented in the film thickness direction to further improve the anisotropic conductivity (fifth invention of the subject application). The phrase "oriented in the film thickness direction" means that the longitudinal directions of the electric conductive particles are perpendicular to the surface of the film.

### Advantageous Effects of Invention

According to the present invention, a film adhesive that has high flexibility, can enhance the adhesion strength, and is composed of components that can be easily mixed can be obtained.

### Brief Description of Drawings

[Fig. 1] The (a) and (b) portions of Fig. 1 are schematic diagrams illustrating a method for measuring the aspect ratio of electric conductive particle used in the present invention.
[Fig. 2] Figure 2 is a schematic cross-sectional view showing the state in which electric conductive particles are oriented in the film thickness direction.

### Description of Embodiments

Embodiments of the present invention will now be described. The examples below do not limit the scope of the present invention. In the descriptions of drawings, same elements are represented by the same reference symbols and redundant descriptions are omitted. The scale of the drawings is not necessarily the same as one in the description.

The present invention provides a film adhesive that includes, as essential components, a bisphenol A phenoxy resin having a molecular weight of 30,000 or more, an epoxy resin having a molecular weight of 500 or less, a glycidyl methacrylate copolymer, a rubber-modified epoxy resin, and a latent hardener.

The glycidyl methacrylate copolymer is a polymer obtained by polymerizing glycidyl methacrylate and another copolymerizable monomer and has an epoxy group branching from the polymer main chain. Since the compatibility with the epoxy resin is enhanced and the phase separation is suppressed, the copolymer is easily mixed with the epoxy resin. Since it is a flexible component, flexibility can be imparted to the film adhesive and the adhesion strength can be enhanced.

In addition to the aforementioned component, the film adhesive further contains a rubber-modified epoxy resin. A rubber-modified epoxy resin is a flexible component as with the glycidyl methacrylate copolymer and can further enhance the flexibility of the film adhesive when the rubber-modified epoxy resin is used in combination with the glycidyl methacrylate copolymer. The blend ratio of the rubber-modified epoxy resin is preferably 1% to 30% by weight relative to the total amount of the epoxy resin and the phenoxy resin.

The rubber-modified epoxy resin may be any epoxy resin having a rubber and/or a polyether in the structure. Specific examples thereof include an epoxy resin intramolecularly chemically bonded with a carboxy group modified butadiene-acrylonitrile elastomer (CTBN modified epoxy resin), and rubber-modified epoxy resins such as acrylonitrile-butadiene rubber-modified epoxy resin (NBR-modified epoxy resin), urethane-modified epoxy resin, and silicone-modified epoxy resin. These may be used alone or in combination.

Among the rubber-modified epoxy resin, NBR-modified epoxy resin is preferably used since the compatibility with the epoxy resin and the phenoxy resin is high.

The weight of the glycidyl methacrylate copolymer per epoxy equivalent is preferably 1000 or less. When the weight per epoxy equivalent is large, i.e., the number of epoxy groups in the molecular chain is small, the compatibility with the epoxy resin is decreased. The epoxy groups in the molecular chain can form a network structure by reacting with the epoxy resin during curing. As a result, thermal expansion under a high-temperature, high-humidity condition can be suppressed, and long-term connection reliability is improved. When the weight per epoxy equivalent is larger than 1000, there are fewer reactive sites to the epoxy resin. Thus, an effective network structure cannot be formed and the heat resistance and moisture resistance are degraded.

The glass transition temperature (Tg) of the glycidyl methacrylate copolymer is preferably lower than the glass transition temperature of the bisphenol A phenoxy resin.
In general, in order to improve the heat resistance and moisture resistance, the glass transition temperature of the resin component in the film adhesive after curing must be increased. This is because a high glass transition temperature decreases the coefficient of thermal expansion in a high temperature range and reduces changes in characteristics in a high-temperature, high-humidity environment.

A phenoxy resin having a high glass transition temperature is often used as a resin component for raising the glass transition temperature after curing. The film adhesive is placed between objects to be connected and heated and pressurized to bond the objects to be connected. Since a phenoxy resin having a high glass transition temperature does not exhibit a sufficient flow property during heating and pressurizing, the resin component remains excessively between the electrodes, which are the objects to be connected, and the remaining resin component is cured into an insulating film that can cause connection failures. When a glycidyl methacrylate copolymer having a glass transition temperature lower than the glass transition temperature of the phenoxy resin is used, the flow property of the film adhesive as a whole can be improved. Note that the glass transition temperature is measured with a setup for dynamic viscoelasticity measurement (dynamic mechanical analysis or DMA).

The glycidyl methacrylate copolymer is a polymer obtained by copolymerizing glycidyl methacrylate with another copolymerizable monomer. Examples of the copolymerizable monomer include acrylic acid and acrylic acid derivatives such as methyl acrylate and acrylic esters; fumaric acid derivatives such as dimethyl fumarate and diethyl fumarate; and styrene and styrene derivatives such as α-methylstyrene. An acrylic acid derivative is preferably used as the copolymerizable monomer since the compatibility between the glycidyl methacrylate copolymer and the epoxy resin and the phenoxy resin can be enhanced.

The molecular weight of the glycidyl methacrylate copolymer is not particularly limited but is preferably 100,000 or less in terms of weight-average molecular weight from the standpoint of the compatibility with the epoxy resin.

The glycidyl methacrylate copolymer content is preferably 1% to 30% by weight relative to the total amount of the epoxy resin and the phenoxy resin. This is because the heat resistance after curing becomes insufficient at a glycidyl methacrylate copolymer resin content exceeding 30%. When the glycidyl methacrylate copolymer resin content is less than 1% by weight, a sufficient effect of improving the flexibility is not obtained and the adhesion strength is lowered. The "resin component" refers to thermosetting and thermoplastic resins such as an epoxy resin, a phenoxy resin, a glycidyl methacrylate copolymer, a rubber-modified epoxy resin, etc.

The epoxy resin used in the present invention rapidly reacts with a curing agent under heating and exhibits a bonding property. The type of the epoxy resin is not particularly limited. Examples of the epoxy resin include bisphenol-type epoxy resins such as those having bisphenol A, F, S, and AD in the structure, novolac-type epoxy resins, biphenyl-type epoxy resins, and dicyclopentadiene-type epoxy resins.

The molecular weight of the epoxy resin is 500 or less. When an epoxy resin having a low molecular weight is used, the crosslink density is increased and the bonding property can be enhanced. Since the epoxy resin rapidly reacts with a curing agent during heating, the adhesion strength is increased.

The phenoxy resin used in the present invention has a high molecular weight among the epoxy resins described above. In the present invention, a bisphenol A phenoxy resin having a molecular weight of 30,000 or more is used. Use of a phenoxy resin having a high molecular weight enhances the film formability. Moreover, the melt viscosity of the resin at a connecting temperature can be increased, and the connection can be established without disturbing the orientation of the conductive particles described below.

When an epoxy resin having a low molecular weight and a phenoxy resin having a high molecular weight are used in combination, the properties of the film adhesive can be balanced. The blend ratio of the epoxy resin to the phenoxy resin is preferably epoxy resin/phenoxy resin = 10/90 to 70/30. The molecular weight is a weight-average molecular weight in terms of polystyrene determined from gel permeation chromatography (GPC) using tetrahydrofuran (THF) as a developing solvent.

The latent hardener used in the present invention may be appropriately selected from known hardeners for epoxy resins. A latent hardener has high storage stability at a low temperature and rarely causes curing reactions at room temperature. However, when it is under particular conditions such as by heating, it rapidly causes curing reactions. Examples of the latent hardeners include imidazole-type curing agents, hydrazide-type curing agents, amine-type curing agents such as boron trifluoride-amine complexes, amine imides, polyamine-type curing agents, tertiary amines, and alkyl urea-type curing agents, dicyandiamide type curing agents, and modified materials thereof. These may be used alone or as a mixture of two or more types.

Of the latent hardeners described above, an imidazole-type latent hardener is preferably used. A known imidazole-type latent hardener can be used as the imidazole-type latent hardener. For example, an adduct of an imidazole compound and an epoxy resin may be used. Examples of the imidazole compound include imidazole, 2-methylimidazole, 2-ethylimidazole, 2-propylimidazole, 2-dodecylimidazole, 2-phenylimidazole, 2-phenyl-4-methylimidazole, and 4-methylimidazole.

These latent hardeners are preferably microencapsulated by being coated with a high molecular material such as a polyurethane type material or a polyester type material, or an inorganic substance such as a metal thin film of nickel, copper, or the like, or calcium silicate since long-term storage property and fast curing property, which are in conflict, can both be sufficiently attained. A microencapsulated imidazole-type latent hardener is thus particularly preferable.

The blend ratio of the latent hardener to the resin components such as the epoxy resin, the phenoxy resin, and the glycidyl methacrylate copolymer is preferably 5% to 90% by weight relative to the total weight of the resin components. At a latent hardener ratio less than 5% by weight, the curing rate is lowered and insufficient curing may result. At a ratio more than 90% by weight, the hardener tends to remain unreacted, and this may degrade the heat resistance and the moisture resistance.

The film adhesive preferably further contains electric conductive particles. A film adhesive containing electric conductive particles can be used as an anisotropic conductive adhesive. Examples of the electric conductive particles include metal particles of gold, silver, copper, nickel, and an alloy thereof, and carbon. Particles prepared by coating surfaces of cores composed of non-conductive glass, ceramic, plastic, or metal oxide with a metal, ITO, or the like to form a conductive layer thereon may also be used. The shape of the electric conductive particles is not particularly limited. Spherical particles or long needle-shaped particles may be used.

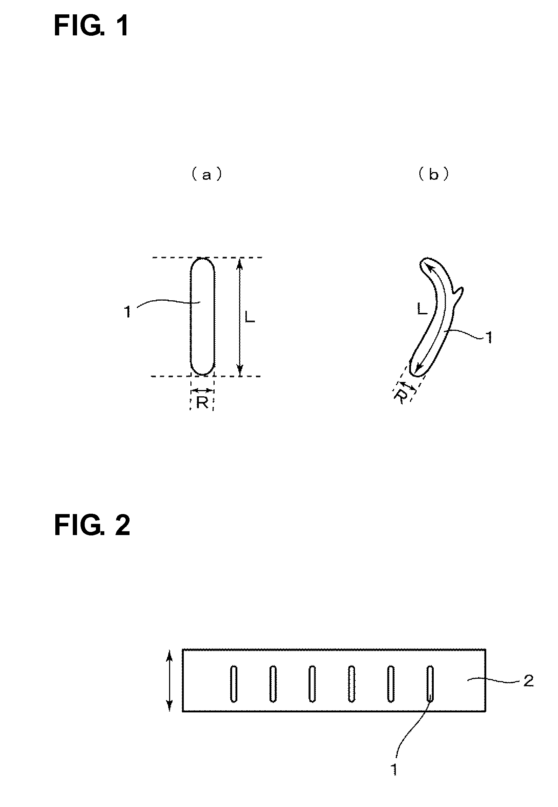

When electric conductive particles having a length-to-diameter ratio (aspect ratio) of 5 or more are used as the electric conductive particles, the connection resistance can be lowered without increasing the electric conductive particle content. Thus, good electric connection can be achieved and the insulation resistance in the surface direction can be maintained high. The aspect ratio of the electric conductive particles is directly measured by charge-coupled device (CCD) microscopy. As shown in the (a) portion of Fig. 1, the aspect ratio is the ratio of the length L to the diameter R of an electric conductive particle 1. The electric conductive particle does not necessary have a straight shape and can be used even when it has some bended and/or branched portions. In such a case, as shown in the (b) portion of Fig. 1, the aspect ratio is determined by assuming the maximum length (the length of the arrow in the drawing) of the electric conductive particle to be the length L. The "diameter" of the electric conductive particle is the diameter of a cross-section taken perpendicular to the length direction. When the cross-section is not circular, the maximum length of the cross-section is assumed to be the diameter of the electric conductive particle.

Commercially available needle-shaped electric conductive particles can be used as the electric conductive particles having an aspect ratio of 5 or more. Needle-shaped particles formed by connecting many fine metal particles are also preferable. More preferably, the aspect ratio is 10 to 100. The electric conductive particles preferably have a diameter of 1 µm or less, since they can connect between fine-pitch electrodes.

Examples of the metal that constitutes the fine metal particles include single metals having ferromagnetism such as Fe, Ni, and Co or a complex of a metal having ferromagnetism. When a metal having ferromagnetism is used, the particles are oriented by their own magnetism or, as described below, electric conductive particles can be oriented by using a magnetic field.

The electric conductive particles having an aspect ratio of 5 or more are preferably oriented in the film thickness direction to further improve the anisotropic conductivity. The phrase "oriented in the film thickness direction" means that the longitudinal directions of the electric conductive particles are perpendicular to the surface of the film. Figure 2 is a schematic cross-sectional view showing a state in which electric conductive particles are oriented in the film thickness direction. Needle-shaped electric conductive particles 1 in a resin component 2 of the film adhesive are oriented in the film thickness direction (direction of arrow in the drawing). The method for orienting the electric conductive particle in the film thickness direction is not particularly limited. When electric conductive particles having ferromagnetism are used as described above, an example of a preferable method for orienting the electric conductive particles is a method that includes dispersing electric conductive particles in a resin solution, applying the resulting dispersion solution on a substrate to which a magnetic field is applied in a direction intersecting the surface of the substrate to orient the electric conductive particles, and solidifying and curing the dispersion solution by, for example, removing the solvent on the substrate so as to fix the orientation.

The electric conductive particle content is selected depending on the usage from the range of 0.01% to 30% by volume relative to the total volume of the film adhesive. In order to prevent degradation of insulation performance in the surface direction by excessive electric conductive particles, the electric conductive particle content is more preferably 0.01% to 10% by volume.

The film adhesive of the present invention may contain other thermosetting resins, thermoplastic resins, and the like, in addition to the essential components described above as long as the essence of the present invention is not impaired. Additives such as a curing promoter, a polymerization retarder, a sensitizer, a silane coupling agent, a flame retardant, and a thixotropic agent may be contained.

The film adhesive of the present invention can be obtained by mixing the aforementioned components. Since the glycidyl methacrylate copolymer used in the present invention has good compatibility with the epoxy resin and the phenoxy resin, mixing is easy and does not require a special agitator. For example, a solution of the resin components can be easily prepared by placing the epoxy resin, the phenoxy resin, the glycidyl methacrylate copolymer, the latent hardener, and the like and a solvent in a container and simply mixing them with a centrifugal type agitating mixer for several minutes. The solution is applied with a roll coater or the like to form a thin film, and the solvent is removed by drying or the like to obtain a film adhesive.

When electric conductive particles are to be used, a film adhesive can be prepared by adding electric conductive particles in the solution of the resin components to prepare a dispersion solution, applying the dispersion solution in the same manner to form a film, and removing the solvent by drying or the like. In order to orient the electric conductive particles, the electrical conductive particles may be passed through a magnetic field applied in the thickness direction of the film adhesive during formation of a film. As the electric conductive particles pass through the magnetic field, they become oriented and the state of the oriented electric conductive particles is fixed during the subsequent step of removing the solvent. Although the thickness of the film adhesive is not particularly limited, it is normally 10 to 50 µm.

### EXAMPLES

### EXAMPLE 1

### (Preparation of coating solutions)

A bisphenol A epoxy resin (Epikote 1256 (molecular weight: about 50,000, Tg: about 98°C) produced by Japan Epoxy Resins Co., Ltd.) as a phenoxy resin, a bisphenol F liquid epoxy resin (Epikote 806 (molecular weight: about 350) produced by Japan Epoxy Resins Co., Ltd.) as an epoxy resin, a glycidyl methacrylate-styrene copolymer (Marproof G-0250S (weight per epoxy equivalent: 310, molecular weight: about 20,000, Tg: about 74°C) produced by NOF Corporation) as a glycidyl methacrylate copolymer, NBR-modified epoxy (TSR960 produced by DIC Corporation) as a rubber-modified epoxy, and a microencapsulated imidazole-type curing agent (NOVACURE HX3932 produced by Asahi Kasei Epoxy Co., Ltd.) as a latent hardener were used in a weight ratio of 50/20/15/15/30. To these materials, a mixed solvent of carbitol acetate and butyl acetate (mixing ratio was 1:1 on a weight basis) was added. Simple mixing was conducted with a centrifugal type agitating mixer for 3 minutes. As a result, a resin solution having a solid content of 60% was prepared. To the resin solution, needle-shaped nickel particles (aspect ratio: 5 to 60) having a length distribution of from 1 µm to 12 µm were added as electric conductive particles so that the electric conductive particle content relative to the total solid content (resin composition + nickel powder) was 0.2% by volume. The mixture was agitated for 3 minutes using a centrifugal type agitating mixer into a homogeneous dispersion so as to prepare a coating solution for the adhesive.

### (Preparation of film adhesive)

The coating solution prepared as above was applied with a doctor blade on a polyethylene terephthalate (PET) film subjected to a releasing treatment, and dried and solidified at 60°C for 30 minutes in a magnetic field having a magnetic flux density of 100 mT. As a result, a film adhesive having a thickness of 20 µm was obtained.

### (Evaluation of connection resistance)

A flexible printed circuit board (FPC) having one hundred twenty four gold-plated copper circuits having a width of 50 µm and a height of 16 µm and being aligned at an interval of 50 µm and a glass board having ITO circuits having a width of 150 µm and being arranged at an interval of 50 µm were prepared. The FPC and the glass board were arranged to oppose each other so as to form a daisy chain through which the connection resistance can be measured at continuous 124 positions, and the film adhesive obtained as above was placed between the FPC and the glass board. While heating to 190°C, a pressure of 5 MPa was applied for 12 seconds to bond the FPC and the glass board. As a result, an assembly of the FPC and the glass board was obtained. The resistance of the assembly was measured at continuous 124 positions connected through the ITO electrode, the film adhesive, and the gold-plated copper circuits by a four-terminal method. The resistance was divided by 124 to determine the connection resistance of one position.

### (Heat and humidity test)

The assembly of the FPC and the glass board was placed in a thermo-hygrostat set to a temperature of 85°C and a humidity of 85% and discharged after 100 hours. Then the connection resistance was measured as described above.

### (Evaluation of adhesion strength)

The FPC was peeled away from the assembly of the FPC and the glass board to measure the 90° peel strength with Autograph AG-500G (produced by Shimadzu Corporation). Measurement of the adhesion strength was conducted on an assembly in the initial state and an assembly after the heat and humidity test.

### COMPARATIVE EXAMPLE 1

A film adhesive having a thickness of 20 µm was prepared as in Example 1 except the rubber-modified epoxy resin was not added and the blend ratio of the components was changed to phenoxy resin/epoxy resin/glycidyl methacrylate copolymer/latent hardener = 50/20/30/30. A series of evaluation was also conducted.

### COMPARATIVE EXAMPLE 2

A film adhesive having a thickness of 20 µm was prepared as in Example 1 except the glycidyl methacrylate copolymer was not added and the blend ratio of the components was changed to phenoxy resin/epoxy resin/rubber-modified epoxy resin/latent hardener = 50/20/30/30. A series of evaluation was also conducted.

### COMPARATIVE EXAMPLE 3

An attempt to make a film adhesive was made as in Example 1 except an OHterminated acrylic rubber (AS- 3000E produced by Negami Chemical Industrial Co., Ltd.) was used instead of the glycidyl methacrylate copolymer. However, the epoxy resin and the acrylic rubber did not mix sufficiently by 3 minutes of centrifugal agitation. The resin solution remained separated and a sheet could not be formed. The results are shown in Table.

**[Table 1]**

| | Connection resistance (initial) | Connection resistance (after 100 hours) | Adhesive strength (initial) | Adhesive strength (after 100 hours) |
|---|---|---|---|---|
| Example 1 | 0. 35 Ω | 0. 50 Ω | 730 g | 520 g |
| Comparative Example 1 | 0. 48 Ω | 1. 3 Ω | 660 g | 460 g |
| Comparative Example 2 | 0. 42 Ω | 0. 76 Ω | 540 g | 330 g |
| Comparative Example 3 | - | - | - | - |

In Example 1 that used the film adhesive of the present invention, the connection resistance was low and did not increase significantly after 100 hours in a high-temperature, high-humidity environment. The adhesion strength was high both in the initial state and after the high-temperature, high-humidity test.

In Comparative Example 1, the reaction rate decreased and the curing did not progress sufficiently presumably due to absence of the rubber-modified epoxy. Although the connection resistance and the adhesion strength in the initial state were satisfactory, they degraded after the high temperature and high humidity test. In Comparative Example 2, the adhesive did not show sufficient flexibility due to absence of the glycidyl methacrylate copolymer. Compared to Example 1, the adhesion strength was low both in the initial state and after the high temperature and high humidity test.

All embodiments and examples disclosed herein are illustrative in all aspects and should not be considered to be limiting. It is intended that the scope of the present invention is defined not by the description presented above but by the claims below and includes meanings equivalent to the scope of the claims and all modifications within the scope.

### Industrial Applicability

A film adhesive according to the present invention is suitable for bonding and electrically connecting substrates, electronic components, etc., so that connection terminals of component parts can be made smaller and narrower in the field that requires smaller and higher function electronic appliances.

### Reference Signs List

1 Electric conductive particle
2 Resin component

[Patent Literature 1]
   Japanese Patent No. 4110589

## Claims

1. A film adhesive comprising, as essential components, a bisphenol A phenoxy resin having a molecular weight of 30,000 or more, an epoxy resin having a molecular weight of 500 or less, a glycidyl methacrylate copolymer, a rubber-modified epoxy resin, and a latent hardener.

2. The film adhesive according to Claim 1, wherein the weight of the glycidyl methacrylate copolymer per epoxy equivalent is 1000 or less.

3. The film adhesive according to Claim 1 or 2, wherein a glass transition temperature of the glycidyl methacrylate copolymer is lower than a glass transition temperature of the bisphenol A phenoxy resin.

4. The film adhesive according to any one of Claims 1 to 3, further comprising electric conductive particles.

5. The film adhesive according to Claim 4, wherein the electric conductive particles have a length-to-diameter ratio (aspect ratio) of 5 or more and are oriented in a film thickness direction.
